Europäisches Patentamt

European Patent Office

Office européen des brevets

(19)

(11) Numéro de publication : **0 017 531**
**B1**

(12) **FASCICULE DE BREVET EUROPÉEN**

(45) Date de publication du fascicule du brevet :
13.06.84

(21) Numéro de dépôt : **80400343.2**

(22) Date de dépôt : **14.03.80**

(51) Int. Cl.³ : **H 01 L 29/80**, H 01 L 29/78,
H 01 L 29/10

(54) **Transistor à effet de champ à fréquence de coupure élevée et son procédé de réalisation.**

(30) Priorité : 28.03.79 FR 7907803
06.09.79 FR 7922301

(43) Date de publication de la demande :
15.10.80 Bulletin 80/21

(45) Mention de la délivrance du brevet :
13.06.84 Bulletin 84/24

(84) Etats contractants désignés :
DE GB IT NL

(56) Documents cités :
EP-A- 0 005 059
FR-A- 2 268 363
US-A- 4 160 261
IEEE TRANSACTIONS ON ELECTRON DEVICES, vol.
ED-25, no. 6, juin 1978 NEW YORK (US) H. MORKOC et
al.: "A study of high-speed normally off and normally
on A10.5Ga0.5As heterojunction gate GaAs FET's
(HJFET)", pages 619-627
JOURNAL OF APPLIED PHYSICS, vol. 50, no. 5, mai
1979 NEW YORK (US) H.C. CASEY et al.: "Investigation of heterojunctions for MIS devices with oxygendoped A IxGa'I-xAs on n-type GaAs", pages 3484-
3491

(73) Titulaire : **THOMSON-CSF**
**173, Boulevard Haussmann**
**F-75379 Paris Cedex 08 (FR)**

(72) Inventeur : **Delagebeaudeuf, Daniel**
**"THOMSON-CSF" SCPI-173, Bld Haussmann**
**F-75360 Paris Cedex 08 (FR)**
Inventeur : **Nuyen, Trongh Linh**
**"THOMSON-CSF" SCPI-173, Bld Haussmann**
**F-75360 Paris Cedex 08 (FR)**

(74) Mandataire : **Taboureau, James et al**
**THOMSON-CSF SCPI 173, Bld Haussmann**
**F-75379 Paris Cedex 08 (FR)**

## Description

La présente invention concerne les dispositifs semiconducteurs de type transistors à effet de champ, et plus spécialement ceux dont les fréquences de coupures se mesurent en gigahertz.

Les dispositifs de type transistors connus travaillent à des fréquences allant jusqu'à quelques gigahertz. Pour accroître leurs fréquences de coupure, plusieurs possibilités s'offrent : changer la structure et les dimensions du dispositif ou changer la nature des matériaux employés pour le réaliser.

Différentes structures sont connues parmi les transistors à effet de champ, couramment désignés par l'abréviation FET de leur nom anglais « field effect transistors » : les MOS-FET, les MES-FET, les FET à jonction, les FET à hétérojonction à grille de type p. Les MOS-FET, dont la structure comprend un empilement métal-oxyde-matériau semiconducteur, d'où le nom de « MOS », fonctionnent pour le silicium en régime d'inversion de type, au voisinage de la couche d'oxyde. En diminuant au maximum les dimensions des électrodes et les distances entre électrodes de façon à diminuer le temps de transfert d'un porteur de charges, on est arrivé à des fréquences de coupure de l'ordre de 5 GHz. Les MOS-FET à base de GaAs existent au stade d'étude au laboratoire et fonctionnent jusqu'à présent en région de déplétion. Leurs performances sont analogues à celles des MES-FET qui seront décrites ci-après.

Les MES-FET, dont la structure plus simple ne comprend plus qu'un métal et un semiconducteur (ME-S) fonctionnent en déplétion, c'est-à-dire que les porteurs de charges sont déviés, sous l'électrode de commande, et pincés entre la zone de déplétion due au champ de cette électrode, et le substrat semi-isolant.

Les FET à jonction ont pour grille le semiconducteur de type opposé à celui qui constitue la zone de déplétion. Les FET à jonction GaAs ont pour grille GaAs de type p.

Les FET à hétérojonction que l'homme de l'art connaît jusqu'à présent, concernent l'utilisation de deux semiconducteurs différents ; celui constituant la grille est de type p. Le transistor travaille en déplétion de charge dans la couche active de type n dopée au niveau supérieur à $10^{16}$ At/cm$^3$.

Les fréquences obtenues avec ces types de FET, bien qu'élevées ne sont pas encore suffisantes, car la multiplication des communications hertziennes, en particulier par satellites, et l'encombrement des bandes de fréquences, amènent à repousser sans cesse les fréquences utilisées vers des bandes non encore exploitées.

C'est pour répondre à ces impératifs qu'un nouveau transistor à effet de champ a été mis au point. Basé sur une hétérojonction entre matériaux de nature différente, son fonctionnement repose sur l'existence d'un canal de type n dont la conductance est modulable par action sur la polarisation d'une grille également de type n. Cette grille est un semiconducteur de bande interdite plus large que celle du matériau supportant le canal, ledit matériau étant le plus pur possible, de type n avec un dopage inférieur à $10^{16}$ At/cm$^3$. La fréquence de coupure d'un tel transistor est environ 30 % supérieure à celle des MES-FET connus.

Ce dispositif semiconducteur constitue un progrès par rapport à l'art antérieur et présente encore deux types de limitation :

— en premier lieu, la barrière de potentiel entre la couche GaAs et la couche $Al_xGa_{1-x}As$ peut ne pas être suffisamment élevée pour éviter une fuite importante de courant due par exemple à l'effet tunnel entre la grille et la couche active lorsque l'on applique une tension positive sur la grille.

— en second lieu, par suite de la disposition source et drain par rapport à la région grille, le courant source-drain traverse deux zones constituées de GaAs faiblement dopé donc très résistif. Les résistances d'accès équivalentes à ces deux zones appelées $R_s$ entre source et grille et $R_d$ entre grille et drain sont élevées. Elles limitent ainsi les performances des transistors à haute fréquence. Les structures proposées permettent déjà de réduire notablement les résistances $R_s$ et $R_d$ en réduisant les dimensions des zones résistives à faible niveau de dopage. Mais les résistances $R_s$ et $R_d$ ainsi obtenues restent cependant plus élevées que celles que l'on rencontre sur des transistors de l'art connu tels que ceux dénommés MES-FET.

L'invention est donc complétée par deux perfectionnements, dont :

— le premier consiste à réduire le courant de fuite entre la grille et la couche active jusqu'à des valeurs comparables à celles que l'on rencontre sur les transistors à effet de champ selon l'art connu. Ce résultat est obtenu en réduisant l'épaisseur de la couche $Al_xGa_{1-x}As$ à quelques dizaines de mm et en intercalant un isolant entre cette couche de $Al_xGa_{1-x}As$ et la métallisation de la grille ;

— et le second, consiste à réduire les résistances d'accès $R_s$ et $R_d$ jusqu'à des valeurs comparables à celles qui sont obtenues sur les transistors à effet de champ selon l'art connu. Ce résultat est obtenu en amenant les régions de source et de drain jusqu'à proximité de la zone d'accumulation d'électrons, laquelle se trouve dans la couche active de GaAs et à proximité de la couche $AlGa_{1-x}As$, supprimant ainsi le parcours du courant source-drain dans les zones résistives à faible niveau de dopage.

De façon plus précise, l'invention consiste en un transistor à effet de champ à fréquence de coupure élevée, comportant, supportées par un substrat semi-isolant, deux régions d'accès dites source et drain et une région de commande composée d'une première couche semiconductrice dite active et d'une seconde couche semiconductrice dite grille, pourvue d'un contact ohmique la couche active et la grille semiconductrices formant une hétérojonction, ce transistor étant caractérisé en ce que :

— la couche active est en n-GaAs de dopage inférieur à $10^{16}$ At/cm$^3$, et d'épaisseur inférieure à 100 mm et la grille est en n-Al$_x$Ga$_{1-x}$As de dopage de l'ordre de $10^{17}$ At/cm$^3$ où $0,2 < x < 1$, une couche d'accumulation d'électrons se formant par transfert à proximité de l'hétérojonction dans la couche active ;

— l'épaisseur de grille (Al$_x$Ga$_{1-x}$Al) comprise entre dix et deux cent mm, en vue de réduire le courant de fuite entre grille et couche active ;

— les régions d'accès, source et drain, sont séparées de la grille par au plus l'épaisseur de la couche active, en vue de réduire les résistances d'accès $R_S$ entre source et grille et $R_B$ entre drain et grille.

L'invention sera mieux comprise grâce aux explications qui suivent lesquelles décrivent des réalisations pratiques et s'appuient sur les figures suivantes qui représentent :

figure 1   coupe schématique d'un MOS-FET selon l'art connu ;

figure 2   coupe schématique d'un MES-FET selon l'art connu ;

figure 3   diagramme des bandes d'énergie d'une hétéro-jonction isotype n-n, correspondant à l'hétérojonction de la figure 1 ;

figure 4   diagramme des bandes d'énergie d'une hétérojonction isotype n-n selon l'invention ;

figure 5   coupe schématique d'un FET à hétérojonction, selon l'invention ;

figure 6   un premier type de transistor FET à hétérojonction, selon l'invention ;

figure 7   un second type de transistor FET à hétérojonction selon l'invention ;

figure 8   un type de transistor à effet de champ à hétérojonction comportant une couche d'isolant selon l'invention ;

figure 9   coupe d'un transistor à effet de champ à hétérojonction isotype n-n selon l'art antérieur mettant en évidence les zones de résistance d'accès ;

figures 10, 11, 12   coupe de plusieurs transistors à effet de champ à hétérojonction de faible résistance d'accès $R_s$ et $R_d$ selon l'invention.

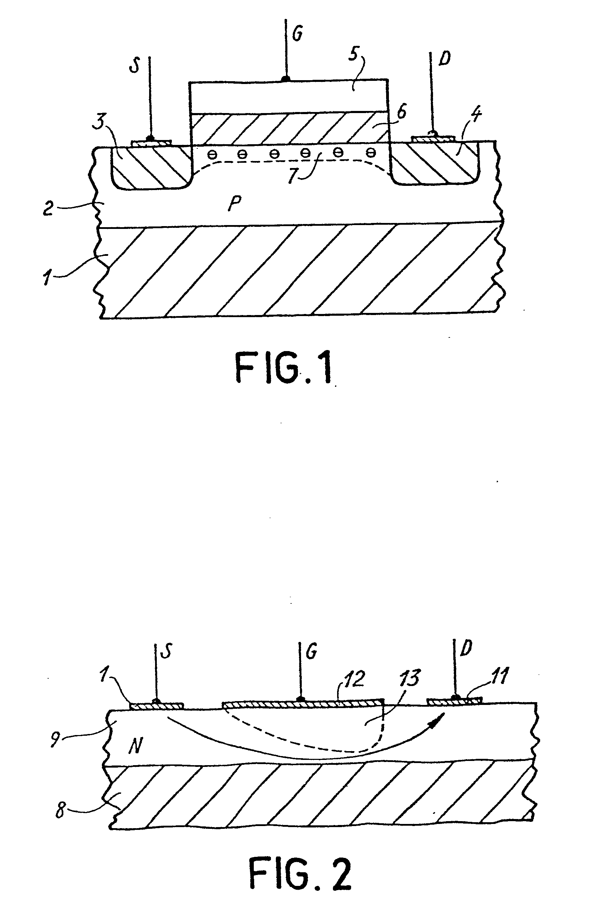

La figure 1 représente un transistor MOS-FET vu en coupe schématiquement.

A un substrat 1 est associée une région 2, obtenue soit par épitaxie soit par diffusion d'impuretés qui modifient la résistivité du matériau de base, cette région 2 étant par exemple de type p. Deux régions 3 et 4 sont diffusées dans la région 2 : l'une constitue l'électrode dite source 3, et l'autre constitue l'électrode dite drain 4, complétées par des métallisations en surface et soudures des fils de connexions. L'électrode de commande 5, dite grille, est constituée par une métallisation déposée sur une couche d'oxyde 6. C'est la raison pour laquelle ce transistor est de type MOS : il est constitué par un métal, un semiconducteur tel que le silicium et son oxyde

SiO$_2$. Ce transistor fonctionne selon un régime dit d'inversion, c'est-à-dire que, sous l'action du champ électrique se forme une couche 7 contre la région d'oxyde 6, les porteurs dans cette couche 7 étant des électrons alors que la région 2 — dans laquelle est créée la couche 7 — est de type p.

Ce type de transistor à inversion de type est limité en fréquence, comme il a été dit, lorsqu'il est réalisé à partir de silicium. Les tentatives avec d'autres matériaux ne sont pas pleinement satisfaisantes : par exemple en utilisant GaAs pour la région 2, on ne sait pas déposer une couche d'oxyde 6 de qualité convenable.

La figure 2 représente un transistor MES-FET vu en coupe, schématiquement.

Sur un substrat semi-isolant 8 est déposée une région 9 d'un matériau semiconducteur de type n par exemple. Les électrodes de source 10, de drain 11 et de grille 12 sont obtenues par métallisation des zones correspondantes à la surface libre de la région 9. Sous l'action d'une tension de commande, les porteurs majoritaires sont pincés entre la région 13 de champ de commande, développée dans la région 9, et la jonction entre les deux régions semiconductrice 9 et semi-isolante 8. Cette structure nécessite un dopage de la couche active supérieur à $10^{16}$ At/cm$^3$, ce qui entraîne une faible mobilité des porteurs de charges.

Le type de transistor à effet de champ, à hétérojonction, isotype selon l'invention, a une fréquence de coupure de l'ordre de 30 % supérieure à celles des transistors MES-FET cités. Ceci est dû aux propriétés particulières de l'hétérojonction GaAs/Al$_x$Ga$_{1-x}$As.

A la différence du couple de matériaux Ga/GaAs où des difficultés d'ordre technologique et peut être de physique, font que l'interface est de qualité médiocre et porteur d'une charge négative fixe importante, le couple GaAs/Al$_x$Ga$_{1-x}$As semble se comporter de façon quasi idéale. La présence d'éventuels pièges ou centres de recombinaison à l'interface n'a pu être révélée et la transition peut être très abrupte. De plus l'absence de charge négative d'interface autorise, dans les structures proposées, l'existence d'une couche d'accumulation électronique côté GaAs. L'hétérojonction satisfait alors au modèle proposé par Anderson dans un article intitulé « germanium gallium arsenide heterojonctions » (IBM journal, juillet 1960, pages 283-287). Cette propriété a été vérifiée par DINGLE et ses collaborateurs dans un article intitulé « Electron mobilities in modulation doped semiconductor heterojonction superlattice » [App. Phys. Lett. vol. 33, n° 7, p. 665 (1978)], sur une structure « superréseau » constituée par un empilement régulier de couches alternativement de GaAs non intentionnellement dopé et de Al$_x$Ga$_{1-x}$As dopé n. Il a mis en évidence, dans les puits de potentiel GaAs, une forte concentration électronique par ségrégation des porteurs mobiles (électrons) par rapport aux impuretés donatrices qui elles, restent dans les couches de Ga$_{1-x}$Al$_x$As et mesuré une

mobilité excellente proche de la mobilité du matériau GaAs non intentionnellement dopé. Il s'agit d'une propriété des couches d'accumulation prédites par Anderson et localisées dans GaAs à chaque interface. La bonne mobilité observée résulterait alors du caractère de pureté du matériau GaAs les supportant les porteurs mobiles confinés dans les couches d'accumulation de GaAs n'entrant ainsi en interaction qu'avec un faible nombre d'impuretés. En résumé, dans le cas d'une hétérojonction isotype nGaAs (peu dopé)/nAl$_x$Ga$_{1-x}$As :

— la transition peut être très abrupte ;

— l'interface est quasi idéale ; peu de pièges, de centres de recombinaison, de charge fixe ;

— il existe une couche électronique d'accumulation dans le matériau GaAs ;

— la mobilité dans la couche d'accumulation est proche de la mobilité en volume du matériau la supportant (GaAs) et donc n'est pas dégradée par le voisinage de l'interface.

Il en résulte que, pour une couche GaAs faiblement dopée où la mobilité en volume est proche de la mobilité limite ($\sim 8\,000$ cm$^2$/v.S), cette caractéristique doit se retrouver dans la couche d'accumulation. Une autre conséquence, importante pour l'invention, est que la vitesse électronique au champ de seuil, marquant le début du transfert électronique intervallées, doit être également élevée dans la couche d'accumulation et atteindre une valeur voisine de $2.10^7$ cm/s caractérisant un matériau très pur.

Cette propriété est appliquée dans la demande de brevet européen 0 005 059 (états désignés DE, FR, GB, NL) déposé le 20.4.79 et publié le 31.10.79 dans laquelle est décrit un transistor à effet de champ à grille Schottky dont la zone active est constituée de telles couches de GaAs et AlGaAs alternées, des métallisations de source, drain et grille étant déposées sur cette structure à couches, de telle façon que le courant circule parallèlement aux couches entre une zone de source et une zone de drain s'étendant à travers la zone active jusqu'au substrat la supportant.

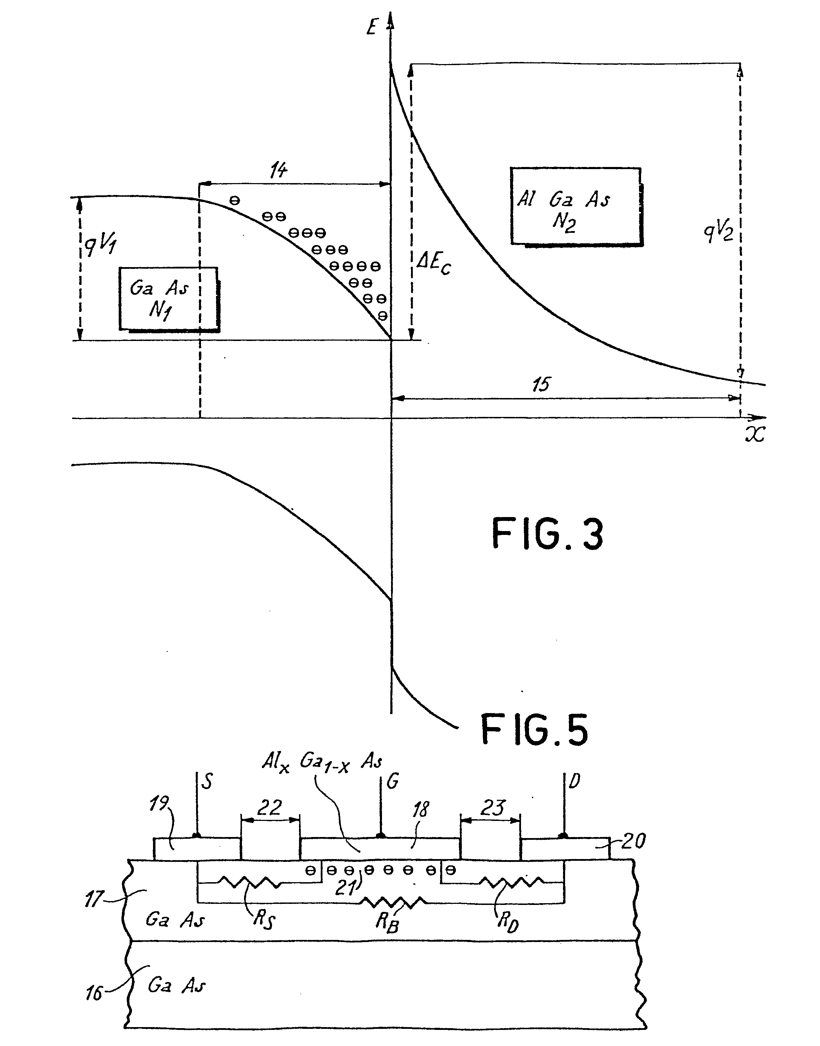

La figure 3 représente le diagramme de bandes d'une hétérojonction GaAs/Al$_x$Ga$_{1-x}$As, isotype n-n, c'est-à-dire que les deux matériaux sont de même type de dopage sous polarisation positive du côté Al$_x$Ga$_{1-x}$As.

L'interface de la jonction étant au milieu des abscisses du diagramme, la bande située d'une part de cette jonction correspond à la région GaAs du transistor, faiblement dopée au niveau n$_1$ et la bande située d'autre part de la jonction correspond à la région Al$_x$Ga$_{1-x}$As de grille du transistor, dopée n également mais à une autre concentration n$_2$.

En ordonnées, sont portées les énergies. Pour une polarisation nulle ou positive de grille, apparaissent au voisinage de la jonction une zone de déplétion 15 dans la grille Al$_x$Ga$_{1-x}$As, et une zone d'accumulation 14 de porteurs majoritaires (électrons) dans la région GaAs.

Une tension positive sur la grille augmente la charge électrique négative de la couche d'accumulation et par là même accroît la conductivité du canal.

Le dopage n$_1$ côté GaAs est choisi le plus faible possible, par exemple $10^{15}$ At/cm$^3$, pour que la mobilité y soit proche de la mobilité limite (8 000 cm$^2$/v.S) et relativement élevée côté Al$_x$Ga$_{1-x}$As (n$_2$) pour que la commande de charge soit efficace, par exemple $10^{17}$ At/cm$^3$. Un dopage n$_2$ élevé est intéressant, mais une limite supérieure liée à l'apparition de l'effet tunnel entre les deux matériaux doit être prise en considération. En restant dans la gamme de quelque $10^{17}$ At/cm$^3$ pour n$_2$, et choisissant par exemple une valeur pour $\Delta E_c$ comprise entre 0,4 et 0,5 eV, l'effet tunnel est limité, de même que l'émission thermoionique. Ce choix de $\Delta E_c$ n'est pas limitatif et dépend de la concentration en aluminium dans Al$_x$Ga$_{1-x}$As.

Ainsi, à des valeurs de charge par unité de surface dans la couche d'accumulation de l'ordre de quelques $10^{-7}$ Cb/cm$^2$, correspond une densité superficielle de majoritaires voisine de $10^{12}$ électrons/cm$^2$, très supérieure à la densité d'états d'interface qui n'excède pas $10^9$ é/cm$^2$, et n'a donc qu'une influence négligeable sur le fonctionnement du transistor.

La figure 4 représente le diagramme de bande d'une structure faisant aussi l'objet de l'invention. Sur une couche 17 de n-GaAs peu dopée sont déposés par tout moyen approprié une couche 18 de Al$_x$Ga$_{1-x}$As dopée n d'épaisseur de l'ordre de quelques dizaines de manomètres puis une couche d'isolant et un dépôt métallique constituant la grille du transistor. Une telle structure minimise fortement le courant de fuite entre GaAs et le métal de grille à cause de la forte barrière de potentiel, plusieurs électrons volts, présentée par l'isolant comme cela est montré sur cette figure 4.

Cette structure proposée également au titre de l'invention diffère de la structure métal isolant semiconducteur classique appelée structure MIS ou MOS par la présence entre le semiconducteur de la couche active GaAs et la couche d'isolant d'une couche mince de Al$_x$Ga$_{1-x}$As. Elle conserve donc l'avantage de l'hétérojonction isotype n-n, c'est-à-dire une bonne mobilité des électrons dans la couche d'accumulation, mais également l'avantage d'un transistor MIS ou d'un MOS par l'existence d'un faible courant de fuite entre la couche active et la grille.

La couche isolante de la structure proposée peut être constituée d'un isolant classique tel que SiO$_2$, SiN$_4$, Al$_2$O$_3$, etc..., déposée sur la couche de Al$_x$Ga$_{1-x}$As. Elle peut aussi résulter d'une oxydation superficielle de la couche Al$_x$Ga$_{1-x}$As.

La figure 5 représente en exemple un transistor FET à hétérojonction à accumulation de majoritaires, par ségrégation dont le schéma de fonctionnement vient d'être décrit.

La région 17 d'un substrat 16 en arséniure de gallium semi-isolant — c'est-à-dire de très forte résistivité — est dopée faiblement, par exemple à $10^{15}$ atomes par centimètre cube environ. Une électrode de grille 18 est déposée sur la région 17. L'électrode de grille est en $Al_xGa_{1-x}As$ dopé à $10^{17}$ atomes par centimètre cube par exemple. Deux électrodes à contact ohmique, réalisées par métallisation, complètent le dispositif, la source est la métallisation 19 et le drain est la métallisation 20. La région d'accumulation 21 est la région située au contact de la jonction $GaAs/Al_xGa_{1-x}As$, sous la grille 18.

Un tel transistor peut pour des dimensions de grille de $1 \times 500$ $\mu m^2$ véhiculer 195 mA, avec une transconductance de 82 mmho et une fréquence de coupure de 32 GHz, pour une tension grille $V_G = 1$ volt, la vitesse maximale des porteurs étant de $2.10^7$ cm/s.

Il s'agit donc d'un dispositif à transconductance et fréquence de coupure relativement élevées pouvant commander des courants assez forts. Il est intéressant de comparer ses performances à celles d'un MES-FET GaAs à déplétion de même géométrie et d'épaisseur de couche active de $0,2$ $\mu$, le dopage étant de $10^{17}$ $At/cm^3$. Pour une vitesse maximale de l'ordre de $1,5$ $10^7$ cm/s, et pour une tension grille $V_G = 0$, un MES-FET véhicule 94 mA, a une transconductance de 60 mmho et une fréquence de coupure de 24 GHz. De plus, dans le cas d'un FET à déplétion, les performances électriques se dégradent fortement aux tensions grilles élevées du fait du principe de fonctionnement mais aussi du fait de la décroissance importante de la vitesse maximale au voisinage de l'interface couche-substrat semi-isolant.

Le dispositif proposé dans la figure 5 est donc avantageux, comparé au MES-FET à déplétion classique sur le plan de la transconductance, de la fréquence de coupure et de l'importance des courants commandés. Par contre, ce transistor possède une résistance parallèle de sortie $R_B$, entre source et drain, assez faible, due à l'épaisseur de couche active de GaAs restée neutre, c'est-à-dire hors de la région d'accumulation. Pour une épaisseur de 100 nm de la région 17 de GaAs, on trouve $R_B = 160$ $\Omega$, valeur qui peut être modifiée en choisissant une épaisseur de couche active 17 plus faible et un matériau plus résistif.

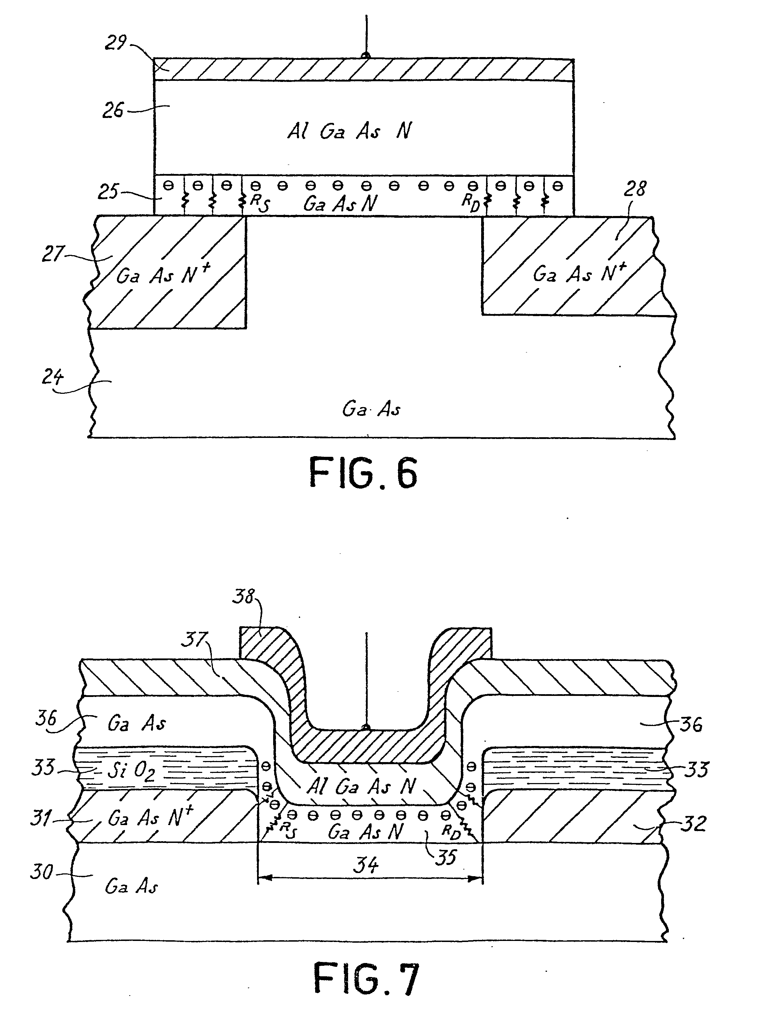

Un autre inconvénient de la structure est lié à la résistivité nécessairement forte de la couche active faiblement dopée conduisant à des résistances d'accès $R_S$ entre source et grille et $R_D$ entre drain et grille à priori très élevées dans cette géométrie, selon laquelle les gardes 22, entre source et grille, et 23, entre drain et grille, sont de l'ordre du micron. Les deux exemples de réalisation montrés en figures 6 et 7, en modifiant la géométrie, tendent à la minimisation de ces résistances d'accès $R_S$ et $R_D$.

Le premier exemple de réalisation d'un transistor FET à hétérojonction, de la figure 6, comporte, comme celui de la figure 5, un substrat 24 en GaAs semi-isolant, une région active 25 en GaAs, faiblement dopé et une région de grille 26 en $Al_xGa_{1-x}As$ dopé n. Cependant, les régions 27 de source et 28 de drain, toutes deux en GaAs de conductivité $n^+$, sont réalisées avant les régions 25 et 26 qui les recouvrent partiellement.

Les couches de source 27 et de drain 28 sont réalisées par diffusion ou implantation, et la couche active 25, épaisse de 100 nm seulement, ainsi que la couche de grille 26 sont réalisées de préférence par épitaxie par faisceau moléculaire.

Le fait que la couche active 25 recouvre partiellement la source et le drain entraîne que les résistances d'accès $R_S$ entre source et grille et $R_D$ entre drain et grille sont réparties, et de plus ne concernent plus qu'une distance d'environ 100 nm, en comparaison des distances 22 et 23 égales à 1 micron, dans la réalisation de la figure 5. Les résistances d'accès $R_S$ et $R_D$ sont très faibles, ce qui permet au transistor d'avoir une fréquence de coupure plus élevée. Les contacts sont pris sur la grille 26 au moyen d'une métallisation 29, et sur les faces libres de la source 27 et du drain 28 au moyen de deux métallisations non représentées sur la figure 6.

La figure 7 représente une autre réalisation de transistor FET à hétérojonction, selon laquelle les résistances d'accès $R_S$ et $R_D$ sont encore réparties à travers l'épaisseur de la couche active, le recouvrement ne se faisant plus par les faces principales des couches, mais par les faces d'extrémités, une couche étant considérée comme un parallélépipède.

Ce transistor est ainsi réalisé : sur un substrat 30 en GaAs semi-isolant sont réalisés la source 31 et le drain 32, tous deux en GaAs dopés $n^+$, puis une couche d'isolement 33 en silice. Un puits étant réservé dans la région désignée 34, entre source et drain, la couche active 35 de GaAs est déposée dans le puits, par épitaxie par faisceau moléculaire de préférence. En fait, lorsque la couche 35 de GaAs est déposée dans le puits, une couche 36 recouvre également la couche 33 de $SiO_2$ : seule la partie 35 de cette couche est conductrice, la couche 36 étant très résistante. La grille 37 en $Al_xGa_{1-x}As$ est alors déposée sur la précédente, dans le seul périmètre du puits, dopée fortement n, avant d'être recouverte par une métallisation 38 de prise de contact. Les dopages sont réalisés selon des techniques classiques avec de tels matériaux : le silicium, le soufre, le sélénium, l'étain par exemple peuvent être utilisés comme agents dopants.

Seule la partie centrale active de ce transistor est représentée sur la figure 7 : les régions 31 de source et 32 de drain ont, comme sur la figure 6, une surface libre permettant de prendre les contacts.

Dans cette forme de réalisation, les épaisseurs sont de l'ordre de 2 à 300 nm pour les couches 31 et 32, ainsi que pour la couche de silice 33, inférieure à 100 nm pour la couche active 35, et 2 à 300 nm pour la grille 37. Ainsi, les résistances d'accès $R_S$ entre source et grille et $R_D$ entre drain et grille sont réparties sur 2 à 300 nm — l'épaisseur de la couche de source et de drain — et, compte tenu de l'amincissement de la couche active 35 dans la partie verticale du puits, ont une longueur inférieure à 100 nm, ce qui favorise les fréquences élevées.

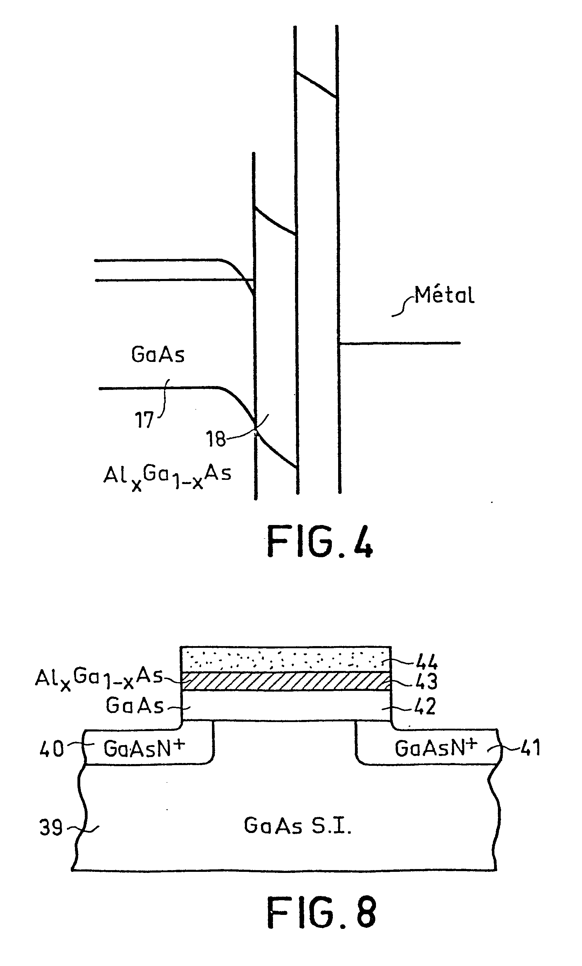

La figure 8 représente un exemple de réalisation d'un transistor à hétérojonction comportant une couche d'isolant. Ce transistor est réalisé sur un substrat 39 en GaAs semi-isolant, deux régions de source 40 et de drain 41 en GaAs dopé $n^+$ sont implantées ou diffusées dans le substrat. Puis sont déposées la couche 42 en GaAs faiblement dopée de type n et la couche 43 en $Al_xGa_{1-x}$-As de quelques dizaines de nm d'épaisseur et enfin la couche 44 d'isolant est formée par l'un des procédés décrits plus haut. Le mésa est ensuite dégagé, c'est-à-dire la partie proéminente constituée par l'empilement GaAs/$Al_xGa_{1-x}$As/isolant.

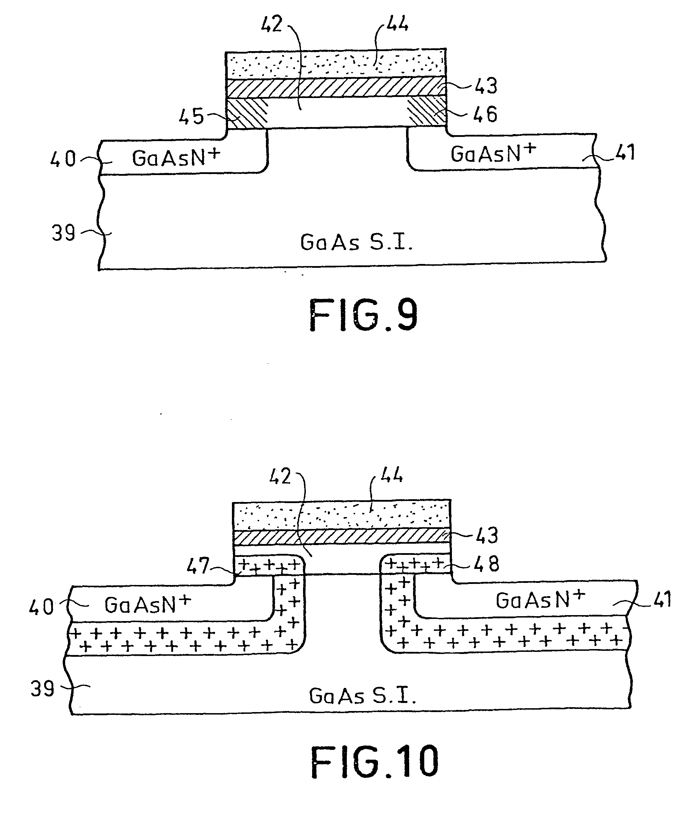

La figure 9 est comparable à la figure 8 mais elle met en évidence les résistances d'accès $R_S$ entre source et grille et $R_D$ entre drain et grille lesquelles résultent en grande partie de l'existence respective des régions 45 et 46 faiblement dopées.

La figure 10 montre comment ces régions 45 et 46 faiblement dopées sont éliminées par extension dans la couche 42 de GaAs jusqu'à la région d'accumulation d'électrons à faible résistivité des zones $n^+$ 47 de source et 48 de drain.

Cette extension de zones $n^+$ dans la couche de GaAs faiblement dopée est obtenue par une diffusion d'impuretés, qui peut se faire selon le procédé suivant.

Des dopants possédant un grand coefficient de diffusion thermique, tel que le soufre, sont d'abord implantés dans le substrat semi-isolant 39 à l'emplacement des zones $n^+$ 40 et 41. Les couches 42 en GaAs faiblement dopées et 43 en $Al_xGa_{1-x}$As dopées n sont ensuite réalisées par épitaxie. L'ensemble de la structure est ensuite recuit de telle façon que les défauts dus à l'implantation soient éliminés et que le dopant diffuse vers les régions 47 et 48. Après avoir déterminé au préalable les profondeurs des régions 47 et 48, en particulier de la couche 42 en GaAs. L'épaisseur de la couche 42 en GaAs est fixée de manière que les régions 47 et 48 pénètrent dans la région d'accumulation d'électrons. Au cours du recuit, des impuretés dopantes contenues dans la couche 43 de $Al_xGa_{1-x}$As diffusent aussi vers la couche 42 de GaAs si l'on ne prend pas soin de ne doper la couche $Al_xGa_{1-x}$-As qu'à une certaine distance de l'interface avec la couche GaAs, ladite distance correspondant à la longueur de diffusion de l'impureté dopant $Al_xGa_{1-x}$As.

L'épaisseur de la couche d'accumulation d'électrons étant de quelques dizaines à quelques centaines de nm, le contrôle de la diffusion est délicat pour que les régions 47 et 48 pénètrent juste dans la couche d'accumulation. Dans un cas limite, les régions 47 et 48 peuvent dépasser la couche d'accumulation d'électrons et peuvent pénétrer dans la couche 43 en $Al_xGa_{1-x}$As car cette couche mince complètement dépeuplée d'électrons ne laisse pas passer le courant entre source et drain.

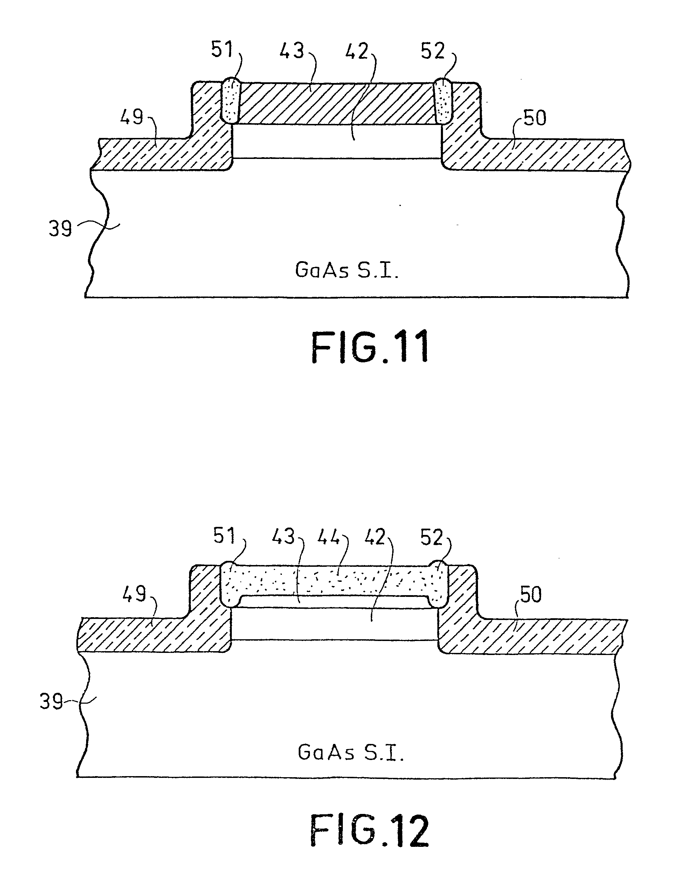

La figure 11 représente un autre exemple de réalisation de transistor à effet de champ à hétérojonction à faible résistance d'accès $R_s$ et

$R_d$. Ce transistor comporte un substrat semi-isolant 39, une couche 42 en GaAs, une grille 43 en $Al_xGa_{1-x}$As. Cependant les sources et drains sont obtenus directement par des métallisations 49 de source et 50 de drain sur le flanc de la partie proéminente constituée par l'empilement des couches GaAs et $Al_xGa_{1-x}$As que l'on appelle mésa.

Ces métallisations recouvrent à la fois les flancs des couches de GaAs et $Al_xGa_{1-x}$As. Elles sont du type prise de contact ohmique sur GaAs, ayant un taux de dopage de l'ordre de $10^{17}$ At par $cm^3$. Elles forment donc un contact ohmique avec la couche d'accumulation d'électrons. Les résistances d'accès $R_s$ et $R_d$ sont par conséquent réduites et strictement limitées à celles des couches d'accumulation.

Pour éviter que les métallisations ne créent un courant de fuite entre source et drain, à travers la couche de $Al_xGa_{1-x}$As. On isole cette dernière des contacts source et drain par des couches d'oxyde 51 et 52 d'épaisseur de l'ordre de quelques centaines de nm. Ces couches s'obtiennent par oxydation superficielle des flancs du mésa. Cette oxydation est beaucoup plus profonde sur la couche $Al_xGa_{1-x}$As que sur la couche GaAs parce que $Al_xGa_{1-x}$As est plus oxydable que GaAs. Avant le dépôt des contacts ohmiques source et drain, la couche superficielle d'oxyde de GaAs est enlevée par les méthodes classiques telle que la pulvérisation cathodique.

La figure 12 représente un autre mode de réalisation de la structure de la figure précédente, le transistor possédant en outre une couche 44 d'isolant déposé sur la grille 43, celle-ci étant mince.

**Revendications**

1. Transistor à effet de champ à fréquence de coupure élevée, comportant, supportées par un substrat semi-isolant (39), deux régions d'accès dites source (40) et drain (41) et une région de commande composée d'une première couche semiconductrice dite active (42) et d'une seconde couche semiconductrice dite grille (43) pourvue d'un contact ohmique, la couche active (42) et la grille (43) semiconductrices formant une hétérojonction, ce transistor étant caractérisé en ce que :

— la couche active (42) est en n-GaAs de dopage inférieur à $10^{16}$ At/$cm^3$ et d'épaisseur inférieure à 100 nm et la grille (43) est en n-$Al_xGa_{1-x}$As de dopage de l'ordre de $10^{17}$ At/$cm^3$ où $0,2 < x < 1$, une couche d'accumulation d'électrons se formant par transfert à proximité de l'hétérojonction dans la couche active,

— l'épaisseur de grille (43) ($Al_xGa_{1-x}$Al) est comprise entre dix et deux cents nm, en vue de réduire le courant de fuite entre grille et couche active,

— les régions d'accès, source (40) et drain (41), sont séparées de la grille (43) par au plus l'épaisseur de la couche active (42), en vue de réduire les résistances d'accès $R_S$ entre source et grille et $R_B$ entre drain et grille.

2. Transistor à effet de champ à fréquence de coupure élevée selon la revendication 1, caractérisé en ce que les régions de source (27, fig. 6) et de drain (28) sont en $n^+$-GaAs, dans le substrat (24), et s'étendent partiellement sous la couche active (25) en n-GaAs, celle-ci (25) et la couche de grille (26) en n-Al$_x$Ga$_{1-x}$As formant un mésa sur le substrat (24).

3. Transistor à effet de champ à fréquence de coupure élevée selon la revendication 1, caractérisé en ce que les régions de source (31, fig. 7) et de drain (32) sont en $n^+$-GaAs déposées sur le substrat (31) et recouverts d'une couche isolante (33), ces régions étant séparées entre elles par un puits (34) occupé par l'hétérojonction constituée de la couche active (35) et de la grille (37), le contact sur les régions de source (31) et de drain (32) se faisant par les faces latérales des couches de source et de drain, un contact métallique ohmique (38) étant déposé sur la grille (37) à l'aplomb dudit puits (34).

4. Transistor à effet de champ à fréquence de coupure élevée selon la revendication 1, caractérisé en ce que les régions de source (49, fig. 11 et 12) et de drain (50) sur le substrat (39) sont en métal qui assure un contact ohmique sur les faces latérales de la couche active (42), déposée sur le substrat, la couche de grille (43), formant hétérojonction avec la couche active (42) étant oxydée sur ses faces latérales (51, 52) en vue d'éviter un contact électrique avec le métal des régions de source (49) et de drain (50).

5. Transistor à effet de champ à fréquence de coupure élevée selon l'une quelconque des revendications 1 à 4, caractérisé en ce que, des métallisations formant contact ohmique étant déposées sur ses régions d'accès (40, 41) et de commande (43), une couche isolante (44) est disposée entre la grille (43) et sa métallisation, en vue de diminuer le courant de fuite.

## Claims

1. Field effect transistor having a high cut-off frequency and comprising two access regions carried by a semi-insulating substrate (39) and referred to as source (40) and drain (41) and a control region composed of a first semiconductor layer referred to as an active layer (42) and a second semiconductor layer referred to as the gate (43) and provided with an ohmic contact, the semiconducting active layer (42) and gate (43) forming a heterojunction, this transistor being characterized in that :

— the active layer (42) is of n-GaAs doped at less than $10^{16}$ At/cm$^3$ and having a thickness of less than 100 nm, and the gate (43) of n-Al$_x$Ga$_{1-x}$As with a doping of the order of $10^{17}$ At/cm$^3$, wherein $0.2 < x < 1$, an electron accumulation layer forming by segregation in the neighborhood of the heterojunction within the active layer,

— the thickness of the gate (43) (Al$_x$Ga$_{1-x}$Al) being comprised within 10 and 200 nm in order to reduce the leakage current between gate and active layer,

— the access regions, source (40) and drain (41), being separated from the gate (43) by at least the thickness of the active layer (42), in order to reduce the access resistance $R_S$ between Source and gate and $R_B$ between drain and gate.

2. Field effect transistor having a high cut-off frequency according to claim 1, characterized in that the source (27, Fig. 6) and drain (28) regions are of $n^+$-GaAs within the substrate (24) and extend partially beneath the active layer (25) of n-GaAs, the latter (25) and the gate layer (26) of n-Al$_x$Ga$_{1-x}$As forming a mesa structure on the substrate (24).

3. Field effect transistor having a high cut-off frequency according to claim 1, characterized in that the source (31, Fig. 7) and drain (32) regions are of $n^+$-GaAs deposited onto the substrate (31) and covered by an insulating layer (33), these regions being separated from each other by a well (34) occupied by the heterojunction formed of the active layer (35) and the gate (37), the contact on the source (31) and drain (32) regions being formed on the lateral faces of the source and drain layers, an ohmic metallic contact (38) being deposited on the gate (37) vertically above said well (34).

4. Field effect transistor having a high cut-off frequency according to claim 1, characterized in that the source (49, Fig. 11 and 12) and drain (50) regions on the substrate (39) are of a metal forming an ohmic contact on the lateral faces of the active layer (42) deposited on the substrate, the gate layer (43) forming the heterojunction with the active layer (42) being oxidized on its lateral faces (51, 52) in order to avoid an electrical contact with the metal of the source (49) and drain (50) regions.

5. Field effect transistor having a high cut-off frequency according to any of claims 1 to 4, characterized in that, the metallizations forming an ohmic contact being deposited on the access (40, 41) and control (43) regions, an insulating layer (44) is deposited between the gate (43) and its metallization in order to reduce the leakage current.

## Ansprüche

1. Feldeffekttransistor mit hoher Grenzfrequenz, welcher zwei von einem halbleitenden Substrat (39) getragene, als Source (40) und Drain (41) bezeichnete Zugangsbereiche sowie einen Steuerbereich aufweist, der aus einer ersten sogenannten aktiven Halbleiterschicht (42) und einer zweiten Halbleiterschicht zusammengesetzt ist, die als Gate (43) bezeichnet wird und mit einem Ohmschen Kontakt versehen ist, wobei die aktive halbleitende Schicht (42) und das halbleitende Gate (43) einen Heteroübergang bilden, wobei dieser Transistor dadurch gekennzeichnet ist, daß :

— die aktive Schicht (42) ist aus n-GaAs mit einer Dotierung von weniger als $10^{16}$ At/cm$^3$ und besitzt eine Dicke von weniger als 100 nm, und das Gate (43) ist aus n-Al$_x$Ga$_{1-x}$As mit einer Dotierung in der Größenordnung von $10^{17}$ At/cm$^3$, worin $0,2 < x < 1$, wobei eine Elektronen-Ansammlungsschicht sich durch Segregation in der Nähe des Heteroüberganges in der aktiven Schicht bildet,

— die Dicke des Gates (43) (Al$_x$Ga$_{1-x}$Al) liegt zwischen 10 und 200 nm, um den Leckstrom zwischen Gate und aktiver Schicht zu vermindern,

— die Zugangsbereiche, Source (40) und Drain (41), sind von dem Gate (43) durch höchstens die Dicke der aktiven Schicht (42) getrennt, um den Zugangswiderstand R$_S$ zwischen Source und Gate bzw. R$_B$ zwischen Drain und Gate zu vermindern.

2. Feldeffekttransistor mit hoher Grenzfrequenz nach Anspruch 1, dadurch gekennzeichnet, daß das Source-Gebiet (27, Fig. 6) und das Drain-Gebiet (28) aus n$^+$-GaAs in dem Substrat (24) gebildet sind und sich teilweise unter der aktiven Schicht (25) aus n-GaAs erstrecken, wobei letztere (25) und die Gate-Schicht (26) aus n-Al$_x$Ga$_{1-x}$As eine Mesastruktur auf dem Substrat (24) bilden.

3. Feldeffekttransistor mit hoher Grenzfrequenz nach Anspruch 1, dadurch gekennzeichnet, daß das Source-Gebiet (31, Fig. 7) und das Drain-Gebiet (32) aus n$^+$-GaAs gebildet und auf dem Substrat (31) abgelagert sowie von einer Isolierschicht (33) bedeckt sind, wobei diese Gebiete untereinander durch einen Schacht (34) getrennt sind, der von dem Heteroübergang eingenommen wird, welcher aus der aktiven Schicht (35) und dem Gate (37) gebildet ist, wobei die Kontaktierung des Source-Gebietes (31) und des Drain-Gebietes (32) an den Seitenflächen der Source-Schicht bzw. der Drain-Schicht erfolgt und ein metallischer Ohmscher Kontakt (38) auf dem Gate (37) senkrecht über dem Schacht (34) aufgebracht ist.

4. Feldeffekttransistor mit hoher Grenzfrequenz nach Anspruch 1, dadurch gekennzeichnet, daß das Source-Gebiet (49, Fig. 11 und 12) und das Drain-Gebiet (50) auf dem Substrat (39) aus einem Metall gebildet sind, welches einen Ohmschen Kontakt an den Seitenflächen der auf dem Substrat abgelagerten aktiven Schicht (42) gewährleistet, wobei die Gate-Schicht (43), welche den Heteroübergang mit der aktiven Schicht (42) bildet, an ihren Seitenflächen (51, 52) oxidiert ist, um einen elektrischen Kontakt mit dem Metall des Source-Gebietes (49) und des Drain-Gebietes (50) zu verhindern.

5. Feldeffekttransistor mit hoher Grenzfrequenz nach einem der Ansprüche 1 bis 4, dadurch gekennzeichnet, daß die einen Ohmschen Kontakt bildenden Metallisierungen auf den Zugangsgebieten (40, 41) und auf dem Steuergebiet (43) aufgebracht sind und eine Isolierschicht (44) zwischen dem Gate (43) und seiner Metallisierung aufgebracht ist, um den Leckstrom zu vermindern.

FIG. 1

FIG. 2

1

FIG.3

FIG.5

FIG. 6

FIG. 7

Métal

GaAs

17

18

$Al_xGa_{1-x}As$

# FIG.4

$Al_xGa_{1-x}As$

GaAs

44
43
42

40 GaAsN$^+$

GaAsN$^+$ 41

39 GaAs S.I.

# FIG.8

42 44

43

45 46

40 GaAsN+ GaAsN+ 41

39 GaAs S.I.

# FIG.9

42 44

43

47 48

40 GaAsN+ GaAsN+ 41

39 GaAs S.I.

# FIG.10

FIG.11

FIG.12